# FASCICULE DE BREVET EUROPEEN

(11) **EP 0 613 254 B1**
(45) Date de publication et mention de la délivrance du brevet: **27.12.1996**
(21) Numéro de dépôt: 94400310.2
(22) Date de dépôt: 11.02.1994
(51) Int. Cl.: H03L 7/23

(54) **Synthétiseur de fréquence**
Frequenzsynthetisierer
Frequency synthesizer

(30) Priorité: 25.02.1993 FR 9302168
(43) Date de publication de la demande: 31.08.1994
(73) Titulaire: DASSAULT ELECTRONIQUE, F-92214 Saint-Cloud (FR)
(72) Inventeur: Potier, Thierry, F-78310 Maurepas (FR)
(74) Mandataire: Plaçais, Jean-Yves

(56) Documents cités:
- DE-A- 3 230 772
- US-A- 3 188 578
- US-A- 4 847 569
- US-A- 5 128 633

## Description

L'invention concerne la synthèse de fréquence.

Elle trouve une application générale en électronique et plus particulièrement en électronique spatiale.

Pour la réalisation de synthèse de fréquence sur une grande plage de fréquence avec un nombre de pas de fréquence élevé, les techniques classiques de synthèse de fréquence notamment celles à base de diviseur programmable ont trois inconvénients :
- une pureté spectrale (rapport signal à bruit) insuffisante au niveau de la fréquence de sortie souhaitée ;
- une présence de raies parasites non harmoniques ; et
- une forte consommation surtout gênante pour les applications spatiales.

Par exemple, DE-A-3 230 772 divulgue un synthétiseur de fréquence assez semblable à celui de l'invention mais présentant implicitement ces inconvénients car il utilise des diviseurs de fréquence programmables et non programmables.

L'invention remédie à ces inconvénients.

Elle porte sur un dispositif synthétiseur de fréquence.

Selon une définition générale de l'invention, le dispositif synthétiseur de fréquence comprend en combinaison :
- un oscillateur modulable en fréquence, possédant une entrée et une sortie ;
- un comparateur de phase possédant une première entrée, une seconde entrée recevant une fréquence de référence et une sortie reliée à l'entrée de l'oscillateur ;
- un générateur de fréquence possédant une entrée recevant la fréquence de référence de valeur F0 et N sorties, avec N nombre entier pouvant être choisi de 1 à N, chaque sortie du générateur de fréquence étant propre à délivrer une fréquence ayant une valeur égale à 2^{N}F0; et
- une boucle à verrouillage de phase comprenant N maillons connectés en série entre la sortie de l'oscillateur et la première entrée du comparateur, chaque maillon comprenant un mélangeur ayant une première entrée reliée à l'une des sorties du générateur de fréquence, une seconde entrée et une sortie, la seconde entrée du mélangeur courant étant reliée à la sortie du mélangeur précédent ou à la sortie de l'oscillateur.

Un tel dispositif a l'avantage de conférer une pureté spectrale satisfaisante au niveau de la fréquence de sortie souhaitée dans la mesure où les éléments qui le constituent apportent des dégradations du bruit de phase faibles.

Avantageusement, le générateur de fréquence comprend N modules connectés en série entre l'entrée et une sortie du générateur de fréquence, chaque module comprenant une entrée reliée à la fréquence de référence de valeur F0 ou à la sortie du module précédent et une sortie propre à délivrer une fréquence égale à 2^{N}FO.

En pratique, pour assurer une faible dégradation du bruit de phase du synthétiseur, chaque module est un circuit doubleur de fréquence présentant un bon rapport signal à bruit.

Selon un aspect de l'invention, au moins une seconde entrée d'un mélangeur est de parité fixe, ce qui permet d'assurer une translation de fréquence de l'oscillateur dans une plage de fréquence prédéterminée.

Par ailleurs, au moins une seconde entrée d'un mélangeur est de parité variable, ce qui permet d'assurer une variation de fréquence de l'oscillateur dans une plage de fréquence prédéterminée.

En pratique, pour positionner le synthétiseur dans une plage de fréquence donnée, il comprend en outre un translateur de fréquence possédant une première entrée recevant une tension de prépositionnement, en particulier issue d'un mot numérique donné, converti en tension par l'intermédiaire d'un convertisseur numérique analogique, une seconde entrée reliée aux moyens de filtrage de la boucle d'asservissement de phase et une sortie reliée à l'entrée de l'oscillateur.

Avantageusement, il est prévu une boucle d'asservissement en fréquence de l'oscillateur comprenant un diviseur possédant une entrée reliée à la sortie de l'oscillateur et une sortie, un compteur possédant une entrée reliée à la sortie du diviseur et une sortie reliée à la première entrée du translateur de fréquence via le convertisseur numérique analogique.

Selon un autre aspect de l'invention, pour réaliser une synthèse de fréquence plus fine, le synthétiseur est combiné avec un étage de synthèse de fréquence supplémentaire comprenant :
- un oscillateur modulable en fréquence supplémentaire possédant une entrée et une sortie ;
- une boucle à verrouillage de phase supplémentaire comprenant un mélangeur supplémentaire possédant une première entrée recevant une fréquence prédéterminée issue du générateur de fréquence, une seconde entrée reliée à la sortie de l'oscillateur supplémentaire et une sortie, un diviseur programmable possédant une entrée reliée à la sortie du mélangeur supplémentaire et une sortie ; et
- un comparateur de phase supplémentaire possédant une première entrée reliée à la sortie du diviseur programmable, une seconde entrée recevant une fréquence de référence supplémentaire et une sortie reliée à l'entrée de l'oscillateur supplémentaire.

De préférence, il comprend également un étage sommateur de fréquence comprenant :
- un oscillateur modulable en fréquence sommateur possédant une entrée et une sortie ;
- une boucle à verrouillage de phase sommatrice comprenant un mélangeur sommateur possédant une première entrée reliée à la sortie de l'oscillateur, une seconde entrée reliée à la sortie de l'oscillateur sommateur et une sortie ; et
- un comparateur de phase sommateur possédant une première entrée reliée à la sortie du mélangeur sommateur, une seconde entrée reliée à la sortie de l'oscillateur supplémentaire et une sortie reliée à l'entrée de l'oscillateur sommateur.

Selon une application particulière de l'invention, la fréquence de référence F0 est de l'ordre de 37,5 MHz, la plage de fréquence de l'oscillateur est de l'ordre de 1237,5 MHz à 2362,5 MHz avec 16 pas de 75 MHz, la plage de fréquence de l'oscillateur supplémentaire est de l'ordre de 375 MHz à 445 MHz avec 15 pas de 5 MHz et la plage de fréquence de l'oscillateur sommateur est de l'ordre de 1612,5 MHz à 2807,5 MHz avec 240 pas de 5 MHz.

D'autres caractéristiques et avantages de l'invention apparaîtront à la lumière de la description détaillée ci-après, et des dessins annexés dans lesquels :
- la figure 1 est une représentation schématique du synthétiseur de fréquence selon l'invention ;
- la figure 2 est une représentation schématique du synthétiseur de fréquence de la figure 1 équipé d'un translateur de fréquence selon l'invention ; et
- la figure 3 est une représentation schématique du synthétiseur de fréquence de la figure 2 combiné avec un étage de synthèse de fréquence supplémentaire et une étage sommateur selon l'invention.

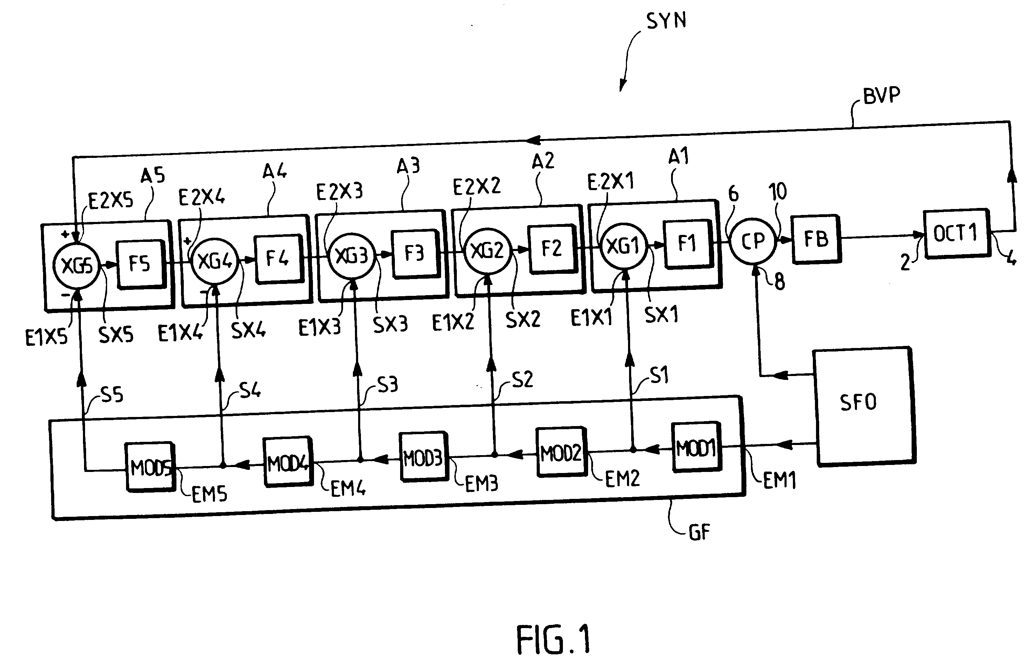

Sur la figure 1, le synthétiseur de fréquence selon l'invention porte la référence SYN.

Il est articulé autour d'un oscillateur modulable en fréquence OCT1 possédant une entrée 2 et une sortie 4.

Un comparateur de phase CP est prévu avec une première entrée 6, une seconde entrée 8 recevant une fréquence de référence F0 et une sortie 10 reliée à l'entrée 2 de l'oscillateur OCT1.

La fréquence de référence F0 est issue d'une source de fréquence SF0.

Selon l'invention, il est prévu un générateur de fréquence GF possédant une entrée EM1 recevant la fréquence de référence F0 et N sorties S1 à SN, avec N nombre entier pouvant être choisi de 1 à N.

Dans le synthétiseur SYN décrit en référence à la figure 1, le nombre entier N est égal à 5.

Bien entendu ce nombre est un exemple non limitatif.

Chaque sortie S1 à S5 du générateur de fréquence est propre à délivrer une fréquence ayant une valeur égale à 2^{N}F0.

Ainsi, la sortie S1 délivre une fréquence égale à 2 F0, la sortie S2 délivre une fréquence égale à 4FO, la sortie S3 délivre une fréquence égale à 8F0, la sortie S4 délivre une fréquence égale à 16F0 et enfin la sortie S5 délivre une fréquence égale à 32F0.

Le synthétiseur comprend enfin une boucle à verrouillage de phase BVP comprenant 5 maillons individualisés en A1 à A5, connectés en série entre la sortie 4 de l'oscillateur OCT1 et la première entrée 6 du comparateur CP.

Chaque maillon A1 à A5 comprend un mélangeur individualisé en XG1 à XG5, ayant une première entrée E1X1 à E1X5 reliée à l'une des sortie S1 à S5 du générateur de fréquence GF, une seconde entrée E2X1 à E2X5 et une sortie SX1 à SX5. La seconde entrée E2X1 à E2X5 du mélangeur courant XG1 à XG5 est reliée à la sortie SX2 à SX4 du mélangeur précédent XG2 à XG4 ou à la sortie 4 de l'oscillateur OCT1.

Avantageusement, le générateur de fréquence GF comprend 5 modules MOD1 à MOD5 connectés en série entre l'entrée EM1 et la sortie S5 du générateur de fréquence GF.

Chaque module MOD1 à MOD5 comprend une entrée individualisée en EM1 à EM5, reliée à la fréquence de référence F0 ou à la sortie S1 à S4 du module précédent MOD1 à MOD4 et une sortie S1 à S5 propre à délivrer une fréquence égale à 2^{N}F0.

En pratique, pour assurer une faible dégradation du bruit de phase du synthétiseur, chaque module MOD1 à MOD5 est un circuit doubleur de fréquence.

Par exemple, le circuit doubleur de fréquence est basé sur un redressement double alternance.

L'homme du métier sait que de tels circuits présentent un bon rapport signal à bruit et consomment peu.

Avantageusement, chaque maillon A1 à A5 comprend en outre des moyens de filtrage F1 à F5 placés en sortie du mélangeur XG1 à XG5 associé audit maillon A1 à A5.

En pratique, les moyens de filtrage F1 à F5 sont du type filtre passe-bas.

Des moyens de filtrage FB de la boucle d'asservissement de phase BVP sont avantageusement prévus entre la sortie 10 du comparateur de phase CP et l'entrée 2 de l'oscillateur OCT1.

En pratique, les moyens de filtrage FB de la boucle d'asservissement de phase sont du type filtre passe-bas de fréquence de coupure élevée.

Selon l'invention, le synthétiseur SYN exploite avantageusement la possibilité de choisir les parités + ou - des entrées des mélangeurs XG1 à XGN de la boucle de phase BVP.

Ainsi, pour assurer une translation de fréquence de l'oscillateur OCT1 dans une plage de fréquence prédéterminée, les secondes entrées E2X4 et E2X5 des mélangeurs XG4 et XG5 sont de parité fixe, ici positive.

Par ailleurs, les secondes entrées E2X1, E2X2 et E2X3 des mélangeurs XG1, XG2 et XG3 sont de parité variable, c'est-à-dire positive ou négative, pour assurer une variation de fréquence de l'oscillateur OCT1 dans une plage de fréquence prédéterminée.

Il en résulte que, lorsque la boucle de phase BVP est accrochée, la fréquence de l'oscillateur OCT1 correspond à l'une des valeurs possibles suivantes :
+/- F0 +/- 2 FO +/- 4 F0 +/- 8 F0 + 16 F0 + 32 F0.

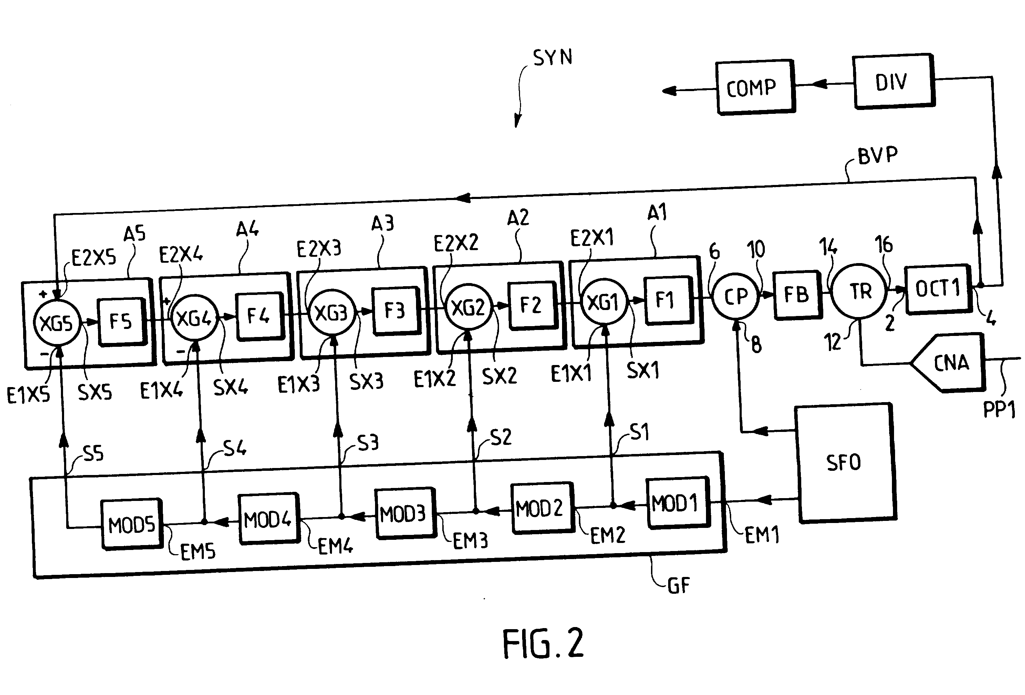

Conformément à la figure 2, pour sélectionner une plage de fréquence souhaitée, le synthétiseur SYN comprend en outre un translateur de fréquence TR possédant une première entrée 12 recevant une tension de prépositionnement PP1 issue d'un mot numérique donné, converti en tension par l'intermédiaire d'un convertisseur numérique analogique CNA, une second entrée 14 reliée aux moyens de filtrage FB de la boucle d'asservissement de phase BVP et une sortie 16 reliée à l'entrée 2 de l'oscillateur OCT1.

Avantageusement, le prépositionnement PP1 est vérifié par l'intermédiaire d'un diviseur DIV possédant une entrée reliée à la sortie 4 de l'oscillateur OCT1 et une sortie, un compteur COMP possédant une entrée reliée à la sortie du diviseur DIV et une sortie reliée à la première entrée 12 du translateur de fréquence TR via une unité de calcul (non représentée) et le convertisseur numérique analogique CNA.

Par exemple, le diviseur DIV est un diviseur par 128.

Les dégradations du bruit de phase apportées par le générateur de fréquence étant négligeables, les performances du synthétiseur dépendent ici de la valeur élevée de la fréquence de coupure de la boucle d'asservissement de phase du synthétiseur.

Dans le cas où la fréquence de référence unique F0 est de l'ordre de 37,5 MHz, une valeur de l'ordre de 1 MHz pour la fréquence de coupure permet de mieux réduire le bruit de phase propre de l'oscillateur OCT1 et reste compatible avec la fréquence de battement supérieure du comparateur de phase CP recevant sur son autre voie 8 la fréquence de référence F0.

Dans une application particulière, par exemple une application spatiale, il est un objectif de l'invention de proposer une grande plage de fréquence avec un nombre de pas de fréquence élevé.

Pour obtenir une telle grande plage de fréquence, il est avantageux d'associer ou de combiner le synthétiseur tel que décrit en référence aux figures 1 et 2 avec un étage de synthèse de fréquence supplémentaire et un étage sommateur.

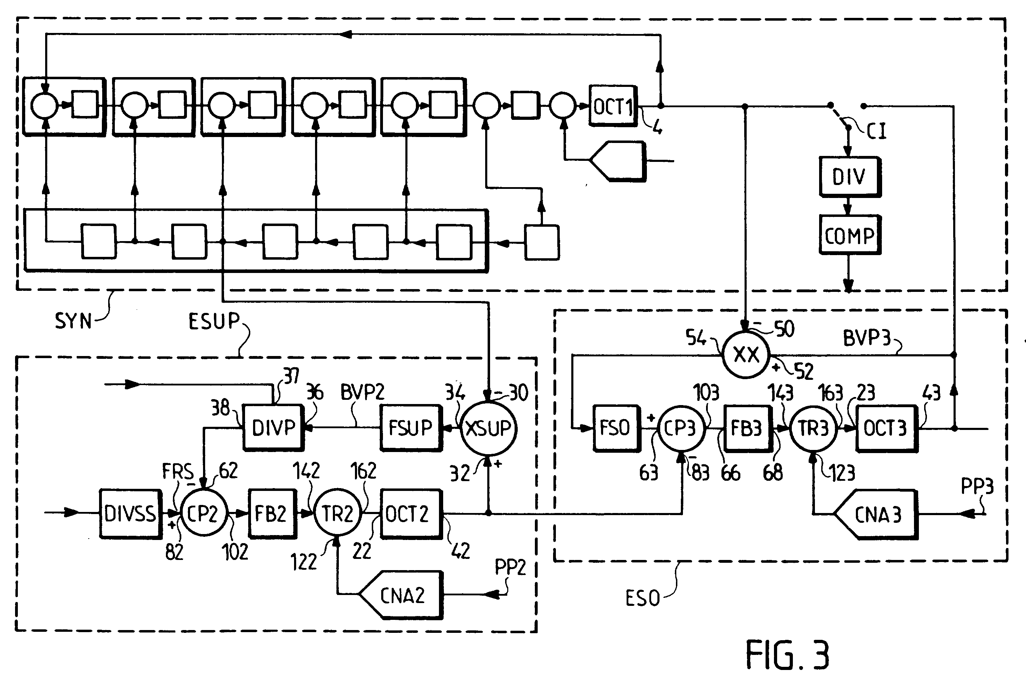

Sur la figure 3, on a représenté une telle combinaison.

L'étage de synthèse de fréquence supplémentaire ESUP est articulé autour d'un oscillateur modulable en fréquence supplémentaire OCT2 possédant une entrée 22 et une sortie 42.

Une boucle à verrouillage de phase supplémentaire BVP2 est prévue avec ledit oscillateur modulable en fréquence supplémentaire OCT2.

La boucle à verrouillage de phase BVP2 comprend un mélangeur supplémentaire XSUP possédant une première entrée 30 recevant une fréquence prédéterminée issue du générateur de fréquence GF, ici 300 MHz, une seconde entrée 32 reliée à la sortie 42 de l'oscillateur supplémentaire et une sortie 34. La boucle à verrouillage de phase est complétée par un diviseur programmable DIVP possédant une entrée 36 reliée à la sortie 34 du mélangeur supplémentaire XSUP et une sortie 38.

Le diviseur programmable DIVP est du type classique. Il reçoit à une entrée 37 un mot numérique sur 4 bits par exemple propre à programmer le pas du diviseur programmable.

Par exemple, le diviseur programmable DIVP présente un pas variant entre 15 et 29.

Des moyens de filtrage FSUP du type passe-bas sont intercalés entre le mélangeur XSUP de l'étage supplémentaire et le diviseur programmable DIVP.

L'étage de synthèse de fréquence supplémentaire comprend en outre un comparateur de phase supplémentaire CP2 possédant une première entrée 62 reliée à la sortie 38 du diviseur programmable DIVP, une seconde entrée 82 recevant une fréquence de référence supplémentaire FRS et une sortie 102 reliée à l'entrée 32 de l'oscillateur supplémentaire OCP2.

Avantageusement, la fréquence de référence supplémentaire FRS est issue du générateur de fréquence GF par exemple de la sortie S1 à travers un diviseur supplémentaire DIVSS propre à diviser la fréquence issue de S1 par 15.

Des moyens de filtrage supplémentaires FB2 de la boucle d'asservissement de phase supplémentaire BVP2 sont prévus entre la sortie 102 du comparateur de phase supplémentaire CP2 et l'entrée 22 de l'oscillateur supplémentaire OCT2.

Comme vu précédemment, il convient également d'équiper l'étage de synthèse de fréquence supplémentaire d'un translateur de fréquence supplémentaire TR2.

Celui-ci possède une première entrée 122 recevant une tension de prépositionnement PP2 issue d'un mot numérique supplémentaire donné, convertie en tension par l'intermédiaire d'un convertisseur numérique analogique supplémentaire CNA2, une seconde entrée 142 reliée aux moyens de filtrage supplémentaires FB2 de la boucle d'asservissement de phase supplémentaire BVP2 et une sortie 162 reliée à l'entrée 22 de l'oscillateur supplémentaire OCT2.

Par exemple, la plage de fréquence de l'oscillateur supplémentaire OCT2 est de l'ordre de 375 MHz à 445 MHz avec 15 pas de 5 MHz.

La fréquence plus basse de l'oscillateur supplémentaire OCT2 et sa relativement faible excursion de fréquence engendrent un faible bruit de phase et par conséquent autorisent une fréquence de coupure basse de la boucle d'asservissement de phase supplémentaire.

Par exemple, la fréquence de coupure est de l'ordre de 20 kHz adaptée au battement supérieur de la comparaison CP2 qui est ici égale à 10 MHz.

Comme vu ci-avant, l'acquisition de l'étage de synthèse supplémentaire ESUP est aidé au moyen d'un prépositionnement par PP2 converti en tension par un convertisseur supplémentaire CNA2 et par un balayage additionnel (non représenté).

Enfin, il est prévu en outre un étage sommateur de fréquences propre à additionner les fréquences issues du synthétiseur SYN et de l'étage de synthèse de fréquence supplémentaire ESUP décrits ci-avant.

L'étage sommateur de fréquences ESO est articulé autour d'un oscillateur modulable en fréquence sommateur OCT3 possédant une entrée 23 et une sortie 43.

L'étage sommateur comprend une boucle à verrouillage de phase sommatrice BVP3 comprenant un mélangeur sommateur XX possédant une première entrée 50 reliée à la sortie 4 de l'oscillateur OCT1, une seconde entrée 52 reliée à la sortie 43 de l'oscillateur sommateur OCT3 et une sortie 54.

En comparateur de phase sommateur CP3 complète l'étage sommateur.

Le comparateur de phase sommateur CP3 possède une première entrée 63 reliée à la sortie 54 du mélangeur sommateur XX, une seconde entrée 83 reliée à la sortie 42 de l'oscillateur supplémentaire OCT2 et une sortie 103 reliée à l'entrée 23 de l'oscillateur sommateur OCT3.

Avantageusement, des moyens de filtrage sommateurs FB3 de la boucle d'asservissement de phase sommatrice BVP3 sont prévus entre la sortie 103 du comparateur de phase sommateur CP3 et l'entrée 23 de l'oscillateur sommateur OCT3.

Tout comme le prépositionnement des oscillateurs OCT1 et OCT2, il est prévu en outre un translateur de fréquence sommateur TR3. Ce translateur TR3 possède une première entrée 123 recevant une tension de prépositonnement PP3 issue d'un mot numérique sommateur donné, converti en tension par l'intermédiaire d'un convertisseur numérique analogique sommateur CNA3, une seconde entrée 143 reliée aux moyens de filtrage sommateurs FB3 et une sortie 163 reliée à l'entrée 23 de l'oscillateur sommateur OCT3.

Tout comme le prépositionnement de l'oscillateur OCT1, l'oscillateur OCT3 est avantageusement asservi par la chaîne diviseur DIV et compteur COMP décrite en référence à la figure 1.

Avantageusement, un commutateur CI est capable de commuter la boucle d'asservissement de fréquence de l'oscillateur OCT1 à l'oscillateur sommateur OCT3 en réponse à une commande prédéterminée.

En pratique, des moyens de filtrage FS0 de type filtre passe-bas sont intercalés entre le mélangeur XX et le comparateur de phase CP3.

Selon les valeurs de fréquence mentionnées ci-avant, la plage de fréquence de l'oscillateur sommateur OCT3 est choisie de l'ordre de 1612,5 MHz à 2807,5 MHz avec 240 pas de 5 MHz.

L'Homme du métier comprendra qu'avec un tel synthétiseur de fréquence, d'excellentes performances de pureté spectrale sont obtenues sur une grande plage de fréquence.

## Revendications

1. Dispositif synthétiseur de fréquence qui comprend en combinaison :
- un oscillateur modulable en fréquence (OCT1) possédant une entrée (2) et une sortie (4),
- un comparateur de phase (CP) possédant une première entrée (6), une seconde entrée (8) recevant une fréquence de référence de valeur FO et une sortie (10) reliée à l'entrée (2) de l'oscillateur (OCT1),
- un générateur de fréquence (GF) possédant une entrée (EM1) recevant la fréquence de référence de valeur FO et N sorties (S1 à SN), et
- une boucle à verrouillage de phase (BVP) comprenant N maillons (A1 à AN) connectés en série entre la sortie (4) de l'oscillateur (OCT1) et la première entrée (6) du comparateur (CP), chaque maillon (A1 à AN) comprenant un mélangeur (XG1 à XGN) ayant une première entrée (E1X1 à E1XN) reliée à l'une des sorties (S1 à SN) du générateur de fréquence (GF), une seconde entrée (E2X1 à E2XN) et une sortie (SX1 à SXN), la seconde entrée (E2X1 à E2XN-1) du mélangeur courant (XG1 à XGN-1) étant reliée à la sortie (SX2 à SXN) du mélangeur précédent (XG2 à XGN) excepté la seconde entrée (E2XN) du premier mélangeur (XGN) qui, elle, est reliée à la sortie (4) de l'oscillateur (OCT1), ledit dispositif synthétiseur étant caractérisé en ce que chaque sortie SJ (S1 à SN) dudit générateur de fréquence (GF) avec J nombre entier pouvant être choisi de 1 à N, est propre à délivrer une fréquence ayant une valeur égale à 2^{J}F0.

2. Dispositif selon la revendication 1, caractérisé en ce que le générateur de fréquence (GF) comprend N modules (MOD1 à MODN) connectés en série entre l'entrée (EM1) et une sortie (SN) du générateur de fréquence (GF), chaque module (MOD1 à MODM) comprenant une entrée (EM1 à EMN) reliée à la fréquence de référence de valeur FO ou à la sortie (S1 à SN-1) du module précédent (MOD1 à MODN-1) et une sortie SJ (S1 à SN) propre à délivrer une fréquence égale à 2^{N}F0.

3. Dispositif selon la revendication 2, caractérisé en ce que chaque module (MOD1 à MODN) est un circuit doubleur de fréquence.

4. Dispositif selon l'une quelconque des précédentes revendications, caractérisé en ce que chaque maillon (A1 à AN) comprend en outre des moyens de filtrage (F1 à FN) placés en sortie du mélangeur (XG1 à XGN) associé audit maillon (A1 à AN).

5. Dispositif selon la revendication 4, caractérisé en ce que les moyens de filtrage (F1 à FN) sont du type passe-bas.

6. Dispositif selon l'une des revendications précédentes, caractérisé en ce que des moyens de filtrage (FB) de la boucle d'asservissement de phase (BVP) sont prévus entre la sortie du comparateur de phase (CP) et l'entrée (2) de l'oscillateur (OCT1).

7. Dispositif selon l'une quelconque des précédentes revendications, caractérisé en ce qu'au moins une seconde entrée (E2X4, E2X5) d'un mélangeur (XG4, XG5)) est de parité fixe, ce qui permet d'assurer une translation de fréquence de l'oscillateur (OCT1) dans une plage de fréquence prédéterminée.

8. Dispositif selon l'une quelconque des précédentes revendications, caractérisé en ce qu'au moins une seconde entrée (E2X1, E2X2, E2X3) d'un mélangeur (XG1,XG2,XG3) est de parité variable, ce qui permet d'assurer une variation de fréquence de l'oscillateur (OCT1) dans une plage de fréquence prédéterminée.

9. Dispositif selon la revendication 6, caractérisé en ce qu'il comprend en outre un translateur de fréquence (TR) possédant une première entrée (12) recevant une tension de prépositionnement (PP1), en particulier issue d'un mot numérique donné, converti en tension par l'intermédiaire d'un convertisseur numérique analogique (CNA), une seconde entrée (14) reliée aux moyens de filtrage (FB) de la boucle d'asservissement de phase (BVP) et une sortie (16) reliée à l'entrée (2) de l'oscillateur (OCT1).

10. Dispositif selon la revendication 9, caractérisé en ce qu'il comprend en outre une boucle d'asservissement en fréquence de l'oscillateur (OCT1) comprenant un diviseur (DIV) possédant une entrée reliée à la sortie (4) de l'oscillateur (OCT1) et une sortie, un compteur (COMP) possédant une entrée reliée à la sortie du diviseur (DIV) et une sortie reliée à la première entrée (12) du translateur de fréquence (TR) via une unité de calcul et le convertisseur numérique analogique (CNA).

11. Dispositif selon l'une quelconque des précédentes revendications, caractérisé en ce qu'il comprend en outre un étage de synthèse de fréquence supplémentaire (ESUP) comprenant:
- un oscillateur modulable en fréquence supplémentaire (OCT2) possédant une entrée (22) et une sortie (42),
- une boucle à verrouillage de phase supplémentaire (BVP2) comprenant un mélangeur supplémentaire (XSUP) possédant une première entrée (30) recevant une fréquence prédéterminée issue du générateur de fréquence (GF), une seconde entrée (32) reliée à la sortie (42) de l'oscillateur supplémentaire (OCT2) et une sortie (34), un diviseur programmable (DIVP) possédant une entrée (36) reliée à la sortie (34) du mélangeur supplémentaire (XSUP) et une sortie (38), et
- un comparateur de phase supplémentaire (CP2) possédant une première entrée (62) reliée à la sortie (38) du diviseur programmable (DIVP), une seconde entrée (82) recevant une fréquence de référence supplémentaire (FRS) et une sortie (102) reliée à l'entrée (22) de l'oscillateur supplémentaire (OCT2).

12. Dispositif selon la revendication 11, caractérisé en ce que des moyens de filtrage supplémentaires (FB2) de la boucle d'asservissement de phase supplémentaire (BVP2) sont prévus entre la sortie (102) du comparateur de phase supplémentaire (CP2) et l'entrée (22) de l'oscillateur supplémentaire (OCT2).

13. Dispositif selon la revendication 12, caractérisé en ce qu'il comprend en outre un translateur de fréquence supplémentaire (TR2) possèdant une première entrée (122) recevant une tension de prépositionnement (PP2), en particulier issue d'un mot numérique supplémentaire donné, converti en tension par l'intermédiaire d'un convertisseur numérique analogique supplémentaire (CNA2), une seconde entrée (142) reliée aux moyens de filtrage supplémentaires (FB2) de la boucle d'asservissement de phase supplémentaire (BVP2) et une sortie (162) reliée à l'entrée (22) de l'oscillateur supplémentaire (OCT2).

14. Dispositif selon l'une des revendications 11 à 13, caractérisé en ce qu'il comprend en outre un étage sommateur de fréquence (ESO) comprenant :
- un oscillateur modulable en fréquence sommateur (OCT3) possèdant une entrée (23) et une sortie (43),
- une boucle à verrouillage de phase sommatrice (BVP3) comprenant un mélangeur sommateur (XX) possèdant une première entrée (50) reliée à la sortie (4) de l'oscillateur (OCT1), une seconde entrée (52) reliée à la sortie (43) de l'oscillateur sommateur (OCT3) et une sortie (54), et
- un comparateur de phase sommateur (CP3) possédant une première entrée (63) reliée à la sortie (54) du mélangeur sommateur (XX) via des moyens de filtrage auxiliaires (FS0), une seconde entrée (83) reliée à la sortie (42) de l'oscillateur supplémentaire (OCT2) et une sortie (103) reliée à l'entrée (23) de l'oscillateur sommateur (OCT3).

15. Dispositif selon la revendication 14, caractérisé en ce que des moyens de filtrage sommateurs (FB3) de la boucle d'asservissement de phase sommatrice (BVP3) sont prévus entre la sortie (103) du comparateur de phase sommateur (CP3) et l'entrée (23) de l'oscillateur sommateur (OCT3).

16. Dispositif selon la revendication 15, caractérisé en ce qu'il comprend en outre un translateur de fréquence sommateur (TR3) possèdant une première entrée (123) recevant une tension de prépositionnement (PP3), en particulier issue d'un mot numérique sommateur donné, converti en tension par l'intermédiaire d'un convertisseur numérique analogique sommateur (CNA3), une seconde entrée (143) reliée aux moyens de filtrage sommateurs (FB3) de la boucle d'asservissement de phase sommatrice (BVP3) et une sortie (163) reliée à l'entrée (23) de l'oscillateur sommateur (OCT3).

17. Dispositif selon la revendication 16, caractérisé en ce qu'il comprend en outre une boucle d'asservissement de fréquence de l'oscillateur sommateur (OCT3) comprenant un diviseur (DIV) possèdant une entrée reliée à la sortie (43) de l'oscillateur sommateur (OCT3) et une sortie, un compteur (COMP) possèdant une entrée reliée à la sortie du diviseur (DIV) et une sortie reliée à la première entrée (123) du translateur de fréquence sommateur (TR3) via une unité de calcul et le convertisseur numérique analogique sommateur (CNA3).

18. Dispositif selon l'une quelconques des précédentes revendications, caractérisé en ce que la fréquence de référence FO est de l'ordre de 37,5 MHz.

19. Dispositif selon la revendication 18, caractérisé en ce que la plage de fréquence de l'oscillateur (OCT1) est de l'ordre de 1237,5 MHz à 2362,5 MHz avec 16 pas de 75 MHz.

20. Dispositif selon la revendication 18, caractérisé en ce que la plage de fréquence de l'oscillateur supplémentaire (OCT2) est de l'ordre de 375 MHz à 445 MHz avec 15 pas de 5 MHz.

21. Dispositif selon les revendications 18 à 20, caractérisé en ce que la plage de fréquence de l'oscillateur sommateur (OCT3) est de l'ordre de 1612,5 MHz à 2807,5 MHz avec 240 pas de 5 MHz.

## Patentansprüche

1. Frequenzsynthetisiervorrichtung, kombiniert umfassend:
- einen frequenzmodulierbaren Oszillator (OCT1) mit einem Eingang (2) und einem Ausgang (4),
- einen Phasenkomparator (CP) mit einem ersten Eingang (6), einem eine Bezugsfrequenz des Werts FO empfangenden zweiten Eingang (8) und einem mit dem Eingang (2) des Oszilltors (OCT1) verbundenen Ausgang (10),
- einen Frequenzgenerator (GF) mit einem die Bezugsfrequenz des Werts FO empfangenden Eingang (EM1) und N Ausgängen (S1 bis SN), und
- einen Phasenverriegelungskreis (BVP) mit N Schleifen (A1 bis AN), in Serie verbunden zwischen dem Ausgang (4) des Oszillators (OCT1) und dem ersten Eingang (6) des Komparators (CP), wobei jede Schleife (A1 bis AN) einen Mischer (XG1 bis XGN) mit einem ersten Eingang (E1X1 bis E1XN), verbunden mit einem der Ausgänge (S1 bis SN) des Frequenzgenerators (GF), einen zweiten Eingang (E2X1 bis E2XN) und einen Ausgang (SX1 bis SXN) umfaßt, wobei der zweite Eingang (E2X1 bis E2XN-1) dieses Mischers (XG1 bis XGN-1) verbunden ist mit dem Ausgang (SX2 bis SXN) des vorangehenden Mischers (XG2 bis XGN), ausgenommen der zweite Eingang (E2XN) des ersten Mischers (XGN), der mit dem Ausgang (4) des Oszillators (OCT1) verbunden ist,
dabei ist besagte Synthetisiervorrichtung **dadurch gekennzeichnet:** daß jeder Ausgang SJ (S1 bis SN) des genannten Frequenzgenerators (GF) mit J als ganzer Zahl, die gewählt werden kann von 1 bis N, eine Frequenz liefern kann, die einen Wert gleich 2^{J}F0 hat.

2. Vorrichtung nach Anspruch 1, dadurch gekennzeichnet, daß der Frequenzgenerator (GF) N Module (MOD1 bis MODN) umfaßt, in Serie verbunden zwischen dem Eingang (EM1) und einem Ausgang (SN) des Frequenzgenerators (GF), wobei jeder Modul (MOD1 bis MODM) einen Eingang (EM1 bis EMN) umfaßt, verbunden mit der Bezugsfrequenz des Werts F0 oder dem Ausgang (S1 bis SN-1) des vorhergehenden Moduls (MOD1 bis MODN-1), und einem Ausgang SJ (S1 bis SN), der eine Frequenz gleich 2^{N}F0 liefern kann.

3. Vorrichtung nach Anspruch 2, dadurch gekennzeichnet, daß jeder Modul (MOD1 bis MODN) eine Frequenzverdopplerschaltung ist.

4. Vorrichtung nach einem der vorangehenden Ansprüche, dadurch gekennzeichnet, daß jede Schleife (A1 bis AN) außerdem Filtriereinrichtungen (F1 bis FN) umfaßt, angeordnet am Ausgang des der besagten Schleife (A1 bis AN) zugeordneten Mischers (XG1 bis XGN).

5. Vorrichtung nach Anspruch 4, dadurch gekennzeichnet, daß die Filtriereinrichtungen (F1 bis FN) vom Tiefpaßtyp sind.

6. Vorrichtung nach einem der vorangehenden Ansprüche, dadurch gekennzeichnet, daß Filtriereinrichtungen (FB) des Phasenregelkreises (BVP) vorgesehen sind zwischen dem Ausgang des Phasenkomparators (CP) und dem Eingang (2) des Oszillators (OCT1).

7. Vorrichtung nach einem der vorangehenden Ansprüche, dadurch gekennzeichnet, daß wenigstens ein zweiter Eingang (E2X4, E2X5) eines Mischers (XG4, XG5) eine feste Parität aufweist, was eine Frequenzübertragung bzw. -verschiebung des Oszillators (OTC1) in einem festgelegten Frequenzbereich ermöglicht.

8. Vorrichtung nach einem der vorangehenden Ansprüche, dadurch gekennzeichnet, daß wenigstens ein zweiter Eingang (E2X1, E2X2, E2X3) eines Mischers (XG1, XG2, XG3) von variabler Parität ist, was eine Frequenzänderung des Oszillators (OTC1) in einem festgelegten Frequenzbereich ermöglicht.

9. Vorrichtung nach Anspruch 6, dadurch gekennzeichnet, daß sie außerdem einen Frequenzübertrager bzw. -verschieber (TR) mit einem ersten Eingang (12) umfaßt, der eine Voreinstellungsspannung (PP1) empfängt, insbesondere abgeleitet von einem bestimmten Digital-wort, in Spannung umgewandelt durch einen Digital-Analog-Wandler (CNA), einen zweiten Eingang (14), verbunden mit den Filtriereinrichtungen (FB) des Phasenregelkreises (BVP), und einen Ausgang (16), verbunden mit dem Eingang (2) des Oszillators (OCT1).

10. Vorrichtung nach Anspruch 9, dadurch gekennzeichnet, daß sie außerdem eine Frequenzregelschleife des Oszillators (OCT1) enthält, umfassend einen Teiler (DIV) mit einem Eingang, verbunden mit dem Ausgang (4) des Oszillators (OCT1), und einem Ausgang, einen Zähler (COMP) mit einem mit dem Ausgang des Teilers (DIV) verbundenen Eingang und einem Ausgang, der verbunden ist mit dem ersten Eingang (12) des Frequenzübertragers bzw. -verschiebers (TR) über eine Recheneinheit und den Digital-Analog-Wandler (CNA).

11. Vorrichtung nach einem der vorangehenden Ansprüche, dadurch gekennzeichnet, daß sie außerdem eine zusätzliche Frequenzsynthesestufe (ESUP) enthält, umfassend:
- einen zusätzlichen frequenzmodulierbaren Oszillator (OCT2) mit einem Eingang (22) und einem Ausgang (42),
- eine zusätzliche Phasenverriegelungsschleife (BVP2), umfassend einen zusätzlichen Mischer (XSUP) mit einem ersten Eingang (30), der eine festgelegte, vom Frequenzgenerator (GF) stammende Frequenz empfängt, einem zweiten Eingang (32), verbunden mit dem Ausgang (42) des zusätzlichen Oszillators (OCT2), und einem Ausgang (34), einen programmierbaren Teiler (DIVP) mit einem Eingang (36), verbunden mit dem Ausgang (34) des zusätzlichen Mischers (XSUP), und einem Ausgang (38), und
- einen zusätzlichen Phasenkomparator (CP2) mit einem ersten Eingang (62), verbunden mit dem Ausgang (38) des programmierbaren Teilers (DIVP), einem zweiten Eingang (82), der eine zusätzliche Bezugsfrequenz (FRS) empfängt, und einem Ausgang (102), verbunden mit dem Eingang (22) des zusätzlichen Oszillators (OCT2).

12. Vorrichtung nach Anspruch 11, dadurch gekennzeichnet, daß die zusätzlichen Filtriereinrichtungen (FB2) des zusätzlichen Phasenregelkreises (BVP2) vorgesehen sind zwischen dem Ausgang (102) des zusätzlichen Phasenkomparators (CP2) und dem Eingang (22) des zusätzlichen Oszillators (OCT2).

13. Vorrichtung nach Anspruch 12, dadurch gekennzeichnet, daß sie außerdem einen zusätzlichen Frequenzübertrager bzw. -verschieber (TR2) mit einem ersten Eingang (122) umfaßt, der eine Voreinstellungsspannung (PP2) erhält, insbesondere abgeleitet von einem bestimmten zusätzlichen Digitalwort, in Spannung umgewandelt durch einen Digital-Analog-Wandler (CNA2), einen zweiten Eingang (142), verbunden mit den Filtriereinrichtungen (FB2) des Phasenregelkreises (BVP2), und einen Ausgang (162), verbunden mit dem Eingang (22) des zusätzlichen Oszillators (OCT2).

14. Vorrichtung nach einem der Ansprüche 11 bis 13, dadurch gekennzeichnet, daß sie außerdem eine Frequenzsummatorstufe (ESO) enthält, umfassend:
- einen frequenzmodulierbaren Summier-Oszillator (OCT3) mit einem Eingang (23) und einem Ausgang (43),
- eine Summier-Phasenverriegelungsschleife (BVP3), umfassend einen Summier-Mischer (XX) mit einem ersten Eingang (50), verbunden mit einem Ausgang (4) des Oszillators (OCT1), einen zweiten Eingang (52), verbunden mit dem Ausgang (43) des Summier-Oszillators (OCT3), und einen Ausgang (54), und
- einen Summier-Phasenkomparator (CP3) mit einem ersten Eingang (63), verbunden mit dem Ausgang (54) des Summier-Mischers (XX) über Hilfsfiltriereinrichtungen (FSO), einem zweiten Eingang (83), verbunden mit dem Ausgang (42) des zusätzlichen Oszillators (OCT2) und einem Ausgang (103), verbunden mit dem Eingang (23) des Summier-Oszillators (OCT3).

15. Vorrichtung nach Anspruch 14, dadurch gekennzeichnet, daß Summier-Filtriereinrichtungen (FB3) des Summier-Phasenregelkreises (BVP3) vorgesehen sind zwischen dem Ausgang (103) des Summier-Phasenkomparators (CP3) und dem Eingang (23) des Summier-Oszillators (OCT3).

16. Vorrichtung nach Anspruch 15, dadurch gekennzeichnet, daß sie außerdem einen Summier-Frequenzübertrager bzw. -Frequenzverschieber (TR3) enthält, umfassend einen ersten Eingang (123), der eine Voreinstellungsspannung (PP3) empfängt, insbesondere abgeleitet von einem bestimmten Digitalwort, in Spannung umgewandelt durch einen Digital-Analog-Wandler (CNA3), einen zweiten Eingang (143), verbunden mit den Summier-Filtriereinrichtungen (FB3) des Summier-Phasenregelkreises (BVP3), und einen Ausgang (163), verbunden mit dem Eingang (23) des Summier-Oszillators (OCT3).

17. Vorrichtung nach Anspruch 16, dadurch gekennzeichnet, daß sie außerdem eine Frequenzregelschleife des Summier-Oszillators (OCT3) enthält, umfassend einen Teiler (DIV) mit einem Eingang, verbunden mit dem Ausgang (43) des Summier-Oszillators (OCT3), und einem Ausgang, einen Zähler (COMP) mit einem mit dem Ausgang des Teilers (DIV) verbundenen Eingang und einem Ausgang, der verbunden ist mit dem ersten Eingang (123) des Frequenzübertragers bzw. -verschiebers (TR3) über eine Recheneinheit und den Digital-Analog-Wandler (CNA3).

18. Vorrichtung nach einem der vorangehenden Ansprüche, dadurch gekennzeichnet, daß die Bezugsfrequenz F0 in der Größenordnung von 37,5 MHz ist.

19. Vorrichtung nach Anspruch 18, dadurch gekennzeichnet, daß der Frequenzbereich des Oszillators (OCT1) in der Größenordnung von 1237,5 MHz bis 2362,5 MHz ist, mit 16 Schritten von 75 MHz.

20. Vorrichtung nach Anspruch 18, dadurch gekennzeichnet, daß der Frequenzbereich des zusätzlichen Oszillators (OCT2) in der Größenordnung von 375 MHz bis 445 MHz ist, mit 15 Schritten von 5 MHz.

21. Vorrichtung nach einem der Ansprüche 18 bis 20, dadurch gekennzeichnet, daß der Frequenzbereich des Summier-Oszillators (OCT3) in der Größenordnung von 1612,5 MHz bis 2807,5 MHz ist, mit 240 Schritten von 5 MHz.

## Claims

1. Frequency synthesizer device which comprises in combination:
- a frequency-alterable oscillator (OCT1) possessing an input (2) and an output (4),
- a phase comparator (CP) possessing a first input (6), a second input (8) receiving a reference frequency of value FO and an output (10) connected to the input (2) of the oscillator (OCT1),
- a frequency generator (GF) possessing an input (EM1) receiving the reference frequency of value FO and N outputs (S1 to SN), and
- a phase-locked loop (BVP) comprising N links (A1 to AN) connected in series between the output (4) of the oscillator (OCT1) and the first input (6) of the comparator (CP), each link (A1 to AN) comprising a mixer (XG1 to XGN) having a first input (E1X1 to E1XN) connected to one of the outputs (S1 to SN) of the frequency generator (GF), a second input (E2X1 to E2XN) and an output (SX1 to SXN), the second input (E2X1 to E2XN-1) of the current mixer (XG1 to XGN-1) being connected to the output (SX2 to SXN) of the preceding mixer (XG2 to XGN) except the second input (E2XN) of the first mixer (XGN) which, for its part, is connected to the output (4) of the oscillator (OCT1), the said synthesizer device being characterized in that each output SJ (S1 to SN) of the said frequency generator (GF), with J an integer which can be chosen from 1 to N, is able to deliver a frequency having a value equal to 2^{J}F0.

2. Device according to Claim 1, characterized in that the frequency generator (GF) comprises N modules (MOD1 to MODN) connected in series between the input (EM1) and an output (SN) of the frequency generator (GF), each module (MOD1 to MODM) comprising an input (EM1 to EMN) connected to the reference frequency of value FO or to the output (S1 to SN-1) of the preceding module (MOD1 to MODN-1) and an output SJ (S1 to SN) able to deliver a frequency equal to 2^{N}FO.

3. Device according to Claim 2, characterized in that each module (MOD1 to MODN) is a frequency doubling circuit.

4. Device according to any one of the preceding claims, characterized in that each link (A1 to AN) furthermore comprises filtering means (F1 to FN) placed at the output of the mixer (XG1 to XGN) associated with the said link (A1 to AN).

5. Device according to Claim 4, characterized in that the filtering means (F1 to FN) are of the low-pass type.

6. Device according to one of the preceding claims, characterized in that filtering means (FB) of the phase slaving loop (BVP) are provided between the output of the phase comparator (CP) and the input (2) of the oscillator (OCT1).

7. Device according to any one of the preceding claims, characterized in that at least one second input (E2X4, E2X5) of a mixer (XG4, XG5) is of fixed parity, thus making it possible to ensure a frequency translation of the oscillator (OCT1) in a predetermined frequency range.

8. Device according to any one of the preceding claims, characterized in that at least one second input (E2X1, E2X2, E2X3) of a mixer (XG1, XG2, XG3) is of variable parity, thus making it possible to ensure a frequency variation of the oscillator (OCT1) in a predetermined frequency range.

9. Device according to Claim 6, characterized in that it furthermore comprises a frequency translator (TR) possessing a first input (12) receiving a presetting voltage (PP1), in particular arising from a given digital word, converted into a voltage by way of a digital-analog converter (CNA), a second input (14) connected to the filtering means (FB) of the phase slaving loop (BVP) and an output (16) connected to the input (2) of the oscillator (OCT1).

10. Device according to Claim 9, characterized in that it furthermore comprises a frequency slaving loop for the oscillator (OCT1) comprising a divider (DIV) possessing an input connected to the output (4) of the oscillator (OCT1) and an output, a counter (COMP) possessing an input connected to the output of the divider (DIV) and an output connected to the first input (12) of the frequency translator (TR) via a computational unit and the digital-analog converter (CNA).

11. Device according to any one of the preceding claims, characterized in that it furthermore comprises a supplementary frequency synthesis stage (ESUP) comprising:
- a supplementary frequency-alterable oscillator (OCT2) possessing an input (22) and an output (42),
- a supplementary phase-locked loop (BVP2) comprising a supplementary mixer (XSUP) possessing a first input (30) receiving a predetermined frequency arising from the frequency generator (GF), a second input (32) connected to the output (42) of the supplementary oscillator (OCT2) and an output (34), a programmable divider (DIVP) possessing an input (36) connected to the output (34) of the supplementary mixer (XSUP) and an output (38), and
- a supplementary phase comparator (CP2) possessing a first input (62) connected to the output (38) of the programmable divider (DIVP), a second input (82) receiving a supplementary reference frequency (FRS) and an output (102) connected to the input (22) of the supplementary oscillator (OCT2).

12. Device according to Claim 11, characterized in that supplementary filtering means (FB2) of the supplementary phase slaving loop (BVP2) are provided between the output (102) of the supplementary phase comparator (CP2) and the input (22) of the supplementary oscillator (OCT2).

13. Device according to Claim 12, characterized in that it furthermore comprises a supplementary frequency translator (TR2) possessing a first input (122) receiving a presetting voltage (PP2), in particular arising from a given supplementary digital word, converted into a voltage by way of a supplementary digital-analog converter (CNA2), a second input (142) connected to the supplementary filtering means (FB2) of the supplementary phase slaving loop (BVP2) and an output (162) connected to the input (22) of the supplementary oscillator (OCT2).

14. Device according to one of Claims 11 to 13, characterized in that it furthermore comprises a frequency summing stage (ESO) comprising:
- a summing frequency-alterable oscillator (OCT3) possessing an input (23) and an output (43),
- a summing phase-locked loop (BVP3) comprising a summing mixer (XX) possessing a first input (50) connected to the output (4) of the oscillator (OCT1), a second input (52) connected to the output (43) of the summing oscillator (OCT3) and an output (54), and
- a summing phase comparator (CP3) possessing a first input (63) connected to the output (54) of the summing mixer (XX) via auxiliary filtering means (FS0), a second input (83) connected to the output (42) of the supplementary oscillator (OCT2) and an output (103) connected to the input (23) of the summing oscillator (OCT3).

15. Device according to Claim 14, characterized in that summing filtering means (FB3) of the summing phase slaving loop (BVP3) are provided between the output (103) of the summing phase comparator (CP3) and the input (23) of the summing oscillator (OCT3).

16. Device according to Claim 15, characterized in that it furthermore comprises a summing frequency translator (TR3) possessing a first input (123) receiving a presetting voltage (PP3), in particular arising from a given summing digital word, converted into a voltage by way of a summing digital-analog converter (CNA3), a second input (143) connected to the summing filtering means (FB3) of the summing phase slaving loop (BVP3) and an output (163) connected to the input (23) of the summing oscillator (OCT3).

17. Device according to Claim 16, characterized in that it furthermore comprises a frequency slaving loop for the summing oscillator (OCT3) comprising a divider (DIV) possessing an input connected to the output (43) of the summing oscillator (OCT3) and an output, a counter (COMP) possessing an input connected to the output of the divider (DIV) and an output connected to the first input (123) of the summing frequency translator (TR3) via a computational unit and the summing digital-analog converter (CNA3).

18. Device according to any one of the preceding claims, characterized in that the reference frequency FO is of the order of 37.5 MHz.

19. Device according to Claim 18, characterized in that the frequency range of the oscillator (OCT1) is of the order of 1237.5 MHz to 2362.5 MHz with 16 steps of 75 MHz.

20. Device according to Claim 18, characterized in that the frequency range of the supplementary oscillator (OCT2) is of the order of 375 MHz to 445 MHz with 15 steps of 5 MHz.

21. Device according to Claims 18 to 20, characterized in that the frequency range of the summing oscillator (OCT3) is of the order of 1612.5 MHz to 2807.5 MHz with 240 steps of 5 MHz.
